# EUROPEAN PATENT APPLICATION

(11) **EP 4 287 410 A1**
(43) Date of publication of application: **06.12.2023**
(21) Application number: 23175671.9
(22) Date of filing: 26.05.2023
(51) Int. Cl.: H01R 9/22, H01R 13/11

(54) **CHARGING BASE LEAD FRAME, CHARGING BASE LEAD FRAME ASSEMBLY AND CHARGING BASE**

(30) Priority: 30.05.2022 CN 202221318765 U
(71) Applicant: Tyco Electronics (Suzhou) Co. Ltd., 215126 Suzhou City Jiangsu (CN); Tyco Electronics Technology (SIP) Ltd., 215026 Suzhou (CN); Tyco Electronics (Shanghai) Co., Ltd., Pilot Free Trade Zone Shanghai 200131 (CN)
(72) Inventor: Zhu, Fangyue, Shanghai, 200233 (CN); Wang, Jinshun, Suzhou, 32 215123 (CN); Wu, Han, Suzhou, 32 215123 (CN)
(74) Representative: Grünecker Patent- und Rechtsanwälte PartG mbB

(57) **Abstract**

The present invention discloses a charging base lead frame, a charging base lead frame assembly, and a charging base. The charging base lead frame comprises of a frame body (2) which is formed with a receiving slot (21); and a plurality of leads (1, 1') which are fixed to the frame body (2) and include a first lead (1) for electrical connection to a terminal (3) of a charging base. The first lead (1) comprises of a lead body (10) which is fixed to the frame body (2); a pair of elastic cantilevers (110) connected to the lead body (10) and suspended in the receiving slot (21) for clamping the terminal (3); and a pair of bridging arms (111) for respectively connecting the fixed ends (110a) of the pair of elastic cantilevers (110) to the lead body (10). At least a portion of the fixed end (110a) of the elastic cantilever (110) is wrapped in the frame body (2). In the present invention, the strength of the root of the elastic cantilever is increased, which can effectively prevent the root of the elastic cantilever from folding backwards when matched with the terminal.

## Description

### CROSS-REFERENCE TO RELATED APPLICATION

This application claims the benefit of Chinese Patent Application No. CN202221318765.6 filed on May 30, 2022 in the State Intellectual Property Office of China, the whole disclosure of which is incorporated herein by reference.

### BACKGROUND OF THE INVENTION

### Field of the Invention

This present invention relates to a charging base lead frame, a charging base lead frame assembly comprising the charging base lead frame, and a charging base including the charging base lead frame or the charging base lead frame assembly.

### Description of the Related Art

In the prior art, the charging base on new energy vehicles typically includes a housing, a charging terminal, a signal terminal, a temperature sensor, and a lead frame. The charging terminal and signal terminal are installed in the housing. The temperature sensor is installed on the lead frame. The lead frame includes a frame body and multiple leads fixed to the frame body. The signal terminal and temperature sensor are electrically connected to the corresponding leads in the lead frame. The lead electrically connected to the signal terminal usually includes a lead body, a pair of elastic cantilevers, and a pair of bridging arms. The pair of bridging arms connect the fixed ends of the pair of elastic cantilevers to the lead body. The signal terminal is clamped between the pair of elastic cantilevers of the lead wire.

In the prior art, the pair of elastic cantilevers and the pair of bridging arms on the lead electrically connected to the signal terminal are exposed from the outside of the frame body. Therefore, when mating the pair of elastic cantilevers with the signal terminal, the roots (fixed ends) of the elastic cantilevers are prone to folding backwards. In the prior art, in order to prevent the root of the elastic cantilever from folding backwards, the width of the bridging arm connected to the root of the elastic cantilever is usually increased. Although increasing the width of the bridging arm will enhance the strength of the root of the elastic cantilever, it will reduce the effective length and elasticity of the elastic cantilever.

### SUMMARY OF THE INVENTION

The present invention has been made to overcome or alleviate at least one aspect of the above mentioned disadvantages.

According to another aspect of the present invention, there is provided a charging base lead frame. The charging base lead frame comprises of a frame body which is formed with a receiving slot; and a plurality of leads which are fixed to the frame body and include a first lead for electrical connection to a terminal of a charging base. The first lead comprises of a lead body which is fixed to the frame body; a pair of elastic cantilevers connected to the lead body and suspended in the receiving slot for clamping the terminal; and a pair of bridging arms for respectively connecting the fixed ends of the pair of elastic cantilevers to the lead body. At least a portion of the fixed end of the elastic cantilever is wrapped in the frame body.

According to an exemplary embodiment of the present invention, a portion of the bridging arm and a portion of the fixed end of the elastic cantilever are wrapped in the frame body; and the part of the fixed end of the elastic cantilever and the part of the bridging arm that are not wrapped in the frame body are suspended in the receiving slot.

According to another exemplary embodiment of the present invention, all of the bridging arm and all of the fixed end of the elastic cantilever are wrapped in the frame body; and the rest part of the elastic cantilever except for the fixed end is exposed from the frame body and suspended in the receiving slot.

According to another exemplary embodiment of the present invention, the bridging arm is located at one side of the width direction of the elastic cantilever and is connected to an side edge of the fixed end of the elastic cantilever.

According to another exemplary embodiment of the present invention, the width direction of the bridging arm is parallel to the length direction of the elastic cantilever, and the width of the bridging arm is smaller than the width of the elastic cantilever.

According to another exemplary embodiment of the present invention, the width of the bridging arm is 10% to 60% of the width of the elastic cantilever; or the width of the bridging arm is 20% to 50% of the width of the elastic cantilever.

According to another exemplary embodiment of the present invention, the one side of the width direction of the bridging arm is flush with the end side of the fixed end of the elastic cantilever; and at least a portion of the bridging arm and at least a portion of the fixed end of the elastic cantilever are wrapped in the frame body.

According to another exemplary embodiment of the present invention, at least a part of the bridging arm is bent relative to the surface of the lead body, so that the surface of the elastic cantilever is roughly perpendicular to the surface of the lead body.

According to another exemplary embodiment of the present invention, the frame body has a protruding part protruding into the receiving slot, and at least a portion of the bridging arm and at least a portion of the fixed end of the elastic cantilever are wrapped in the protruding part.

According to another exemplary embodiment of the present invention, the frame body has a front and a back, and the frame body has a limit beam located on its back and bridging between the two sides of the receiving slot; the limit beam is located between the pair of elastic cantilevers and extends along the length direction of the elastic cantilevers; when the terminal is installed on the charging base lead frame, one end of the terminal is inserted between the free ends (b) of the pair of elastic cantilevers, and the end face of the one end of the terminal is against the limit beam.

According to another exemplary embodiment of the present invention, a through hole is formed in the frame body to allow a charging terminal to pass through.

According to another exemplary embodiment of the present invention, the plurality of leads also include a second lead for electrical connection to a temperature sensor of the charging base; the pins of the first lead and the second lead are exposed from one side of the frame body and arranged in a row.

According to another exemplary embodiment of the present invention, the first lead further includes a pair of guide wings, which are respectively connected to one sides of the free ends of the pair of elastic cantilevers; the pair of guide wings are flared outward in an octagonal shape to guide the one end of the terminal to be inserted between the free ends of the pair of elastic cantilevers.

According to another exemplary embodiment of the present invention, each of the plurality of leads is an integrated stamping molded part, the frame body and the plurality of leads are formed into an integrated injection molded part, so that the frame body is directly bonded to the plurality of leads.

According to another aspect of the present invention, there is provided a charging base lead frame assembly. The charging base lead frame assembly comprises of the above charging base lead frame; and a temperature sensor which is installed on the frame body of the charging base lead frame to detect a temperature of a charging terminal of a charging base. The temperature sensor is electrically connected to the second lead in the charging base lead frame.

According to another aspect of the present invention, there is provided a charging base. The charging base comprises of a housing; the above charging base lead frame or the above charging base lead frame assembly which is installed in the housing; and a terminal which is installed in the housing and clamped between the pair of elastic cantilevers of the first lead of the charging base lead frame.

According to an exemplary embodiment of the present invention, the terminal is a signal terminal.

According to another exemplary embodiment of the present invention, the charging base further comprises a charging terminal which is installed in the housing and passes through the charging base lead frame.

In the aforementioned exemplary embodiments of the present invention, as at least a portion of the fixed end of the elastic cantilever or at least a portion of the bridging arm connected to the fixed end of the elastic cantilever is wrapped and fixed in the frame body, the strength of the root of the elastic cantilever is increased, which can effectively prevent the root of the elastic cantilever from folding backwards when matched with the terminal.

In addition, in the aforementioned exemplary embodiments of the present invention, the width of the bridging arm is reduced to increase the effective length and elasticity of the elastic cantilever.

### BRIEF DESCRIPTION OF THE DRAWINGS

The above and other features of the present invention will become more apparent by describing in detail exemplary embodiments thereof with reference to the accompanying drawings, in which:
Figure 1 shows an illustrative perspective view of a charging base lead frame according to an exemplary embodiment of the present invention;
Figure 2 shows an illustrative perspective view of multiple leads in the charging base lead frame according to an exemplary embodiment of the present invention;
Figure 3 shows an illustrative perspective view of one first lead among multiple leads in the charging base lead frame according to an exemplary embodiment of the present invention;
Figure 4 shows an illustrative partially enlarged view of the first lead shown in Figure 3 when viewed from the upper side;
Figure 5 shows an illustrative partially enlarged view of the first lead shown in Figure 3 when viewed from the bottom;
Figure 6 shows an illustrative perspective view of the first lead and terminal matching shown in Figure 3;
Figure 7 shows an illustrative perspective view of a charging base lead frame according to an exemplary embodiment of the present invention, where only one first lead is shown;
Figure 8 shows an illustrative view of a pair of elastic cantilevers between the first lead wire inserted into the charging base lead frame; and
Figure 9 shows a plan view of the charging base lead frame and terminals according to an exemplary embodiment of the present invention when viewed from the rear.

### DETAILED DESCRIPTION OF PREFERRED EMBODIMENTS OF THE IVENTION

Exemplary embodiments of the present disclosure will be described hereinafter in detail with reference to the attached drawings, wherein the like reference numerals refer to the like elements. The present disclosure may, however, be embodied in many different forms and should not be construed as being limited to the embodiment set forth herein; rather, these embodiments are provided so that the present disclosure will be thorough and complete, and will fully convey the concept of the disclosure to those skilled in the art.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

According to a general concept of the present invention, there is provided a charging base lead frame. The charging base lead frame comprises of a frame body which is formed with a receiving slot; and a plurality of leads which are fixed to the frame body and include a first lead for electrical connection to a terminal of a charging base. The first lead comprises of a lead body which is fixed to the frame body; a pair of elastic cantilevers connected to the lead body and suspended in the receiving slot for clamping the terminal; and a pair of bridging arms for respectively connecting the fixed ends of the pair of elastic cantilevers to the lead body. At least a portion of the fixed end of the elastic cantilever is wrapped in the frame body.

According to another general concept of the present invention, there is provided a charging base lead frame assembly. The charging base lead frame assembly comprises of: the above charging base lead frame; and a temperature sensor which is installed on the frame body of the charging base lead frame to detect a temperature of a charging terminal of a charging base. The temperature sensor is electrically connected to the second lead in the charging base lead frame.

According to another general concept of the present invention, there is provided a charging base. The charging base comprises of: a housing; the above charging base lead frame or the above charging base lead frame assembly which is installed in the housing; and a terminal which is installed in the housing and clamped between the pair of elastic cantilevers of the first lead of the charging base lead frame.

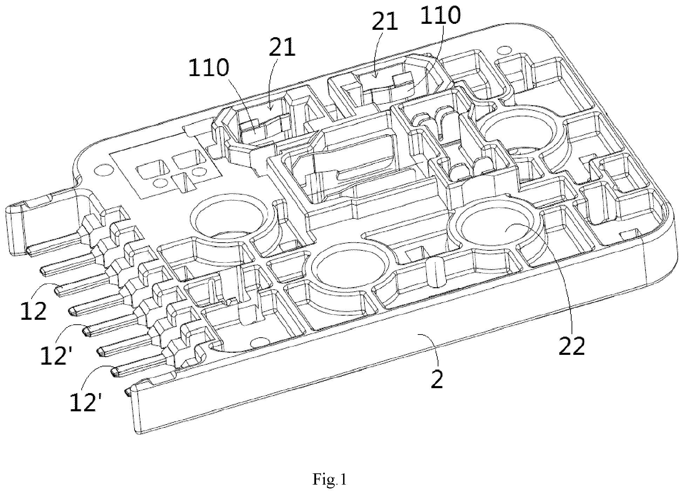

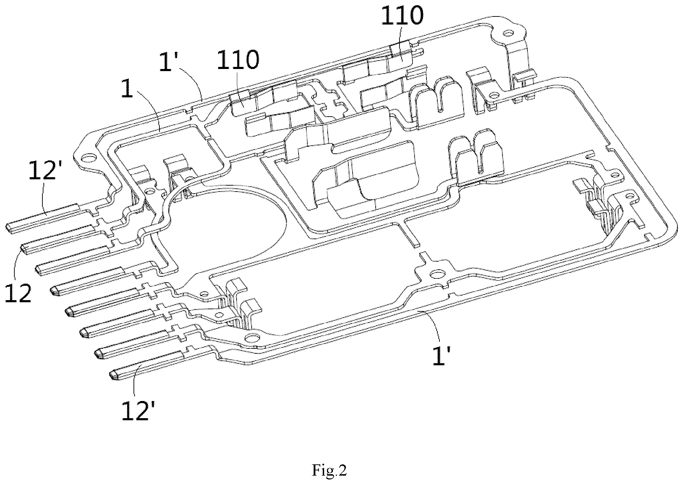

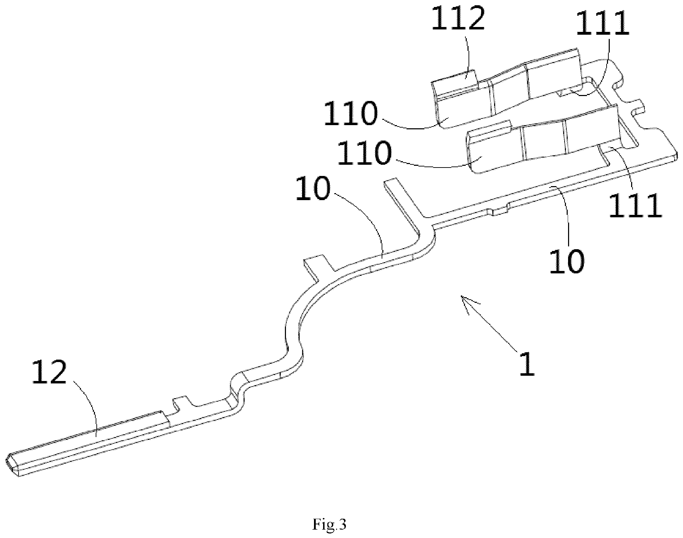

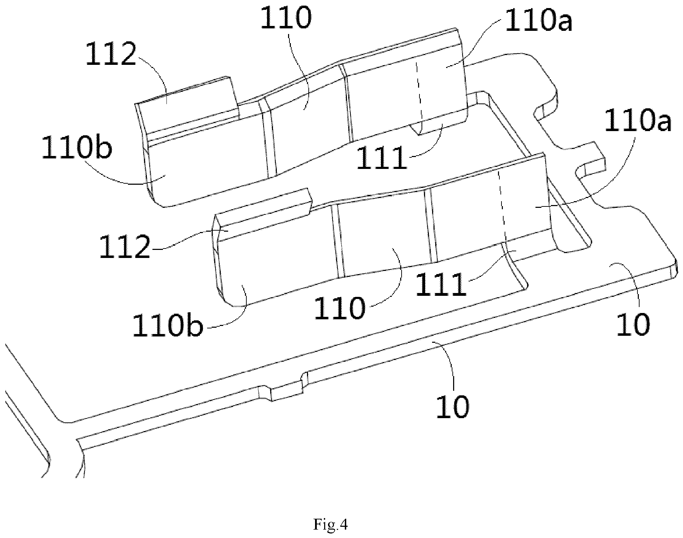

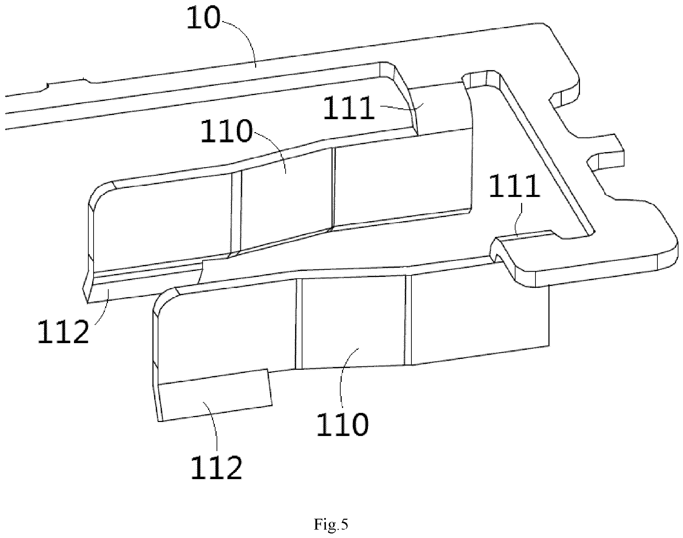

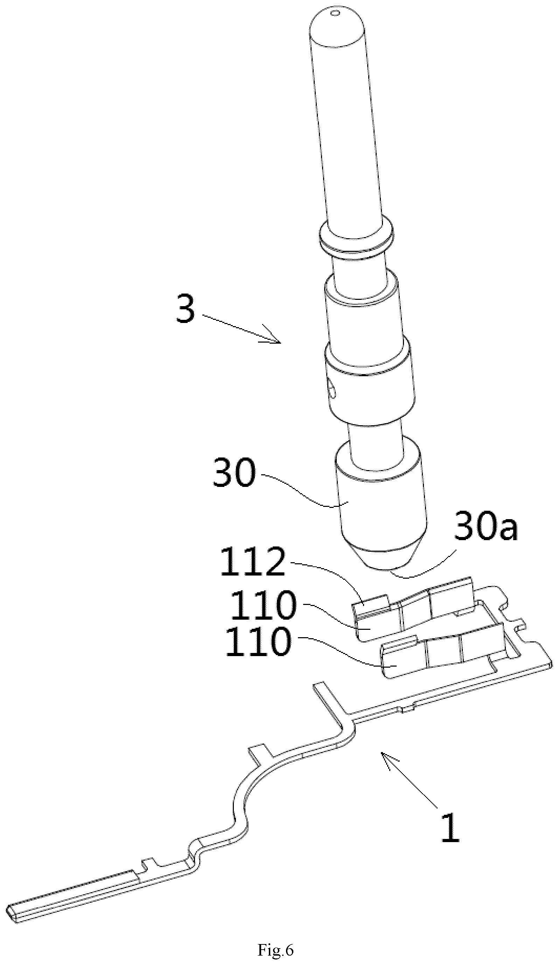

Figure 1 shows an illustrative perspective view of a charging base lead frame according to an exemplary embodiment of the present invention; Figure 2 shows an illustrative perspective view of multiple leads 1, 1' in the charging base lead frame according to an exemplary embodiment of the present invention; Figure 3 shows an illustrative perspective view of the first lead 1 among multiple leads 1 and 1' in the charging base lead frame according to an exemplary embodiment of the present invention; Figure 4 shows an illustrative partially enlarged view of the first lead 1 shown in Figure 3 when viewed from the upper side; Figure 5 shows an illustrative partially enlarged view of the first lead 1 shown in Figure 3, viewed from the bottom; Figure 6 shows an illustrative perspective view of the first lead 1 mated with terminal 3 as shown in Figure 3.

As shown in Figures 1 to 6, in the illustrated embodiment, the charging base lead frame includes: a frame body 2 and multiple leads 1, 1'. A receiving slot 21 is formed on the frame body 2. Multiple leads 1 and 1' are fixed to frame body 2.

As shown in Figures 1 to 6, in the illustrated embodiment, multiple leads 1, 1' include a first lead 1 for electrical connection to a terminal 3 of the charging base. The first lead 1 includes: a lead body 10, a pair of elastic cantilevers 110, and a pair of bridging arms 111. The lead body 10 is fixed to the frame body 2. The pair of elastic cantilevers 110 are connected to the lead body 10 and suspended in the receiving slot 21 for clamping the terminal 3. The pair of bridging arms 111 is used to connect the fixed ends 110a of the pair of elastic cantilevers 110 to the lead body 10 respectively.

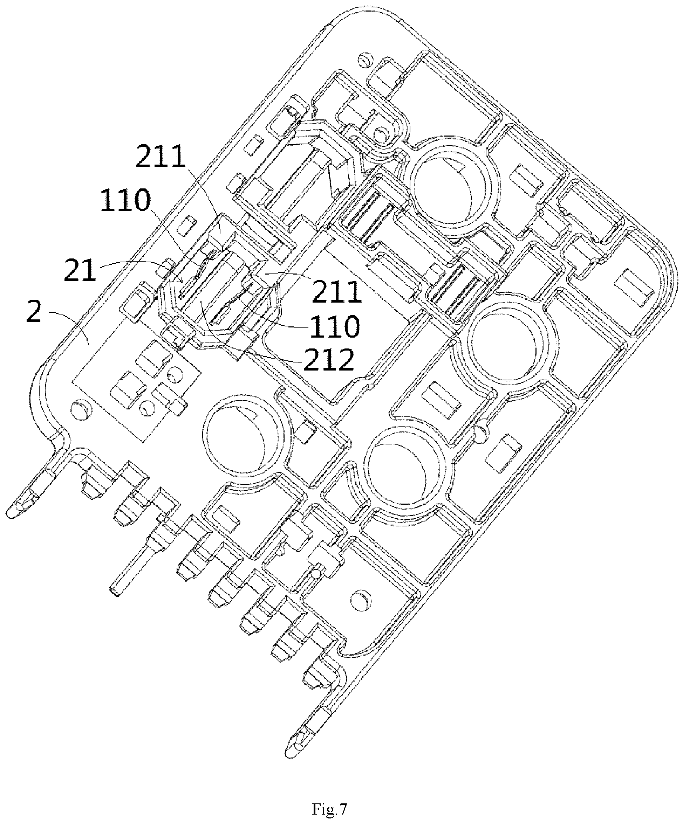

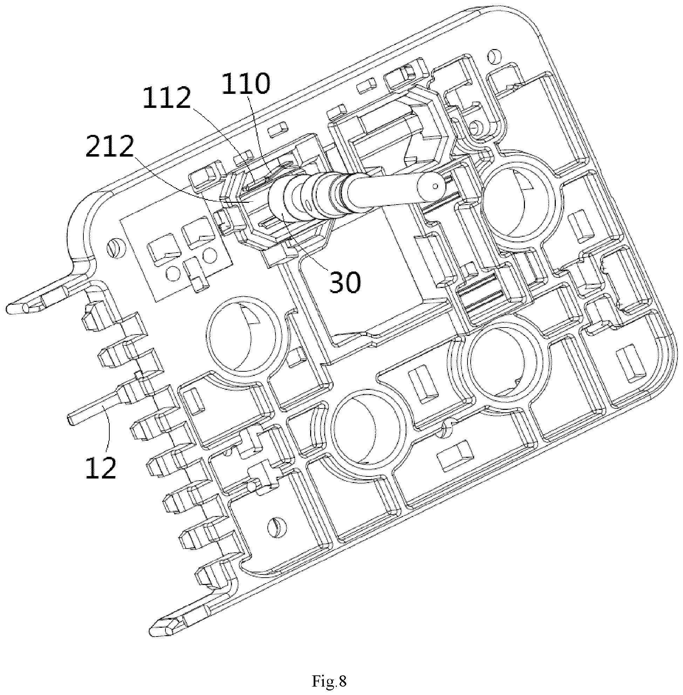

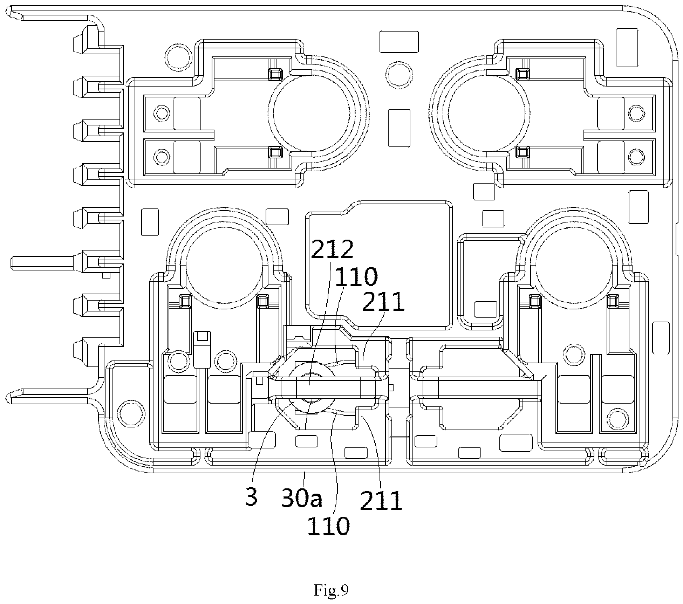

Figure 7 shows an illustrative perspective view of a charging base lead frame according to an exemplary embodiment of the present invention, where only one first lead 1 is shown; Figure 8 shows an illustrative view of a pair of elastic cantilevers 110 between the first lead 1 inserted into the charging base lead frame; Figure 9 shows a plan view of the charging base lead frame and terminal 3 viewed from the rear according to an exemplary embodiment of the present invention.

As shown in Figures 1 to 9, in an exemplary embodiment of the present invention, at least a portion of the bridging arm 111 and/or at least a portion of the fixed end 110a of the elastic cantilever 110 are wrapped in the frame body 2. In this way, the strength of the root of the elastic cantilever 110 can be enhanced, and it can effectively prevent the root of the elastic cantilever 110 from folding backwards when mated with the terminal 3.

As shown in Figures 1 to 9, in the illustrated embodiments, all of the bridging arm 111 and all of the fixed end 110a of the elastic cantilever 110 are wrapped in the frame body 2. The rest part of the elastic cantilever 110 except for the fixed end 110a is exposed from the frame body 2 and suspended in the receiving slot 21.

However, the present invention is not limited to the illustrated embodiments. For example, in another exemplary embodiment of the present invention, a portion of the bridging arm 111 and/or a portion of the fixed end 110a of the elastic cantilever 110 are wrapped in the frame body 2. And the part of the fixed end 110a of the elastic cantilever 110 and the part of the bridging arm 111 that are not wrapped in the frame body 2 are suspended in the receiving slot 21.

As shown in Figures 1 to 9, in the illustrated embodiments, the bridging arm 111 is located at one side of the width direction of the elastic cantilever 110 and connected to the side edge of the fixed end 110a of the elastic cantilever 110. The width direction of bridging arm 111 is parallel to the length direction of elastic cantilever 110, and the width of bridging arm 111 is smaller than the width of elastic cantilever 110.

As shown in Figures 1 to 9, in the illustrated embodiments, the width of the bridging arm 111 can be 10% to 60% of the width of the elastic cantilever 110, or the width of the bridging arm 111 can be 20% to 50% of the width of the elastic cantilever 110. In this way, the effective length and elasticity of the elastic cantilever 110 can be increased by reducing the width of the bridging arm 111.

As shown in Figures 1 to 9, in the illustrated embodiment, one side of the width direction of the bridging arm 111 is flush with the end side of the fixed end 110a of the elastic cantilever 110; And at least a portion of the bridging arm 111 and at least a portion of the fixed end 110a of the elastic cantilever 110 are wrapped in the frame body 2.

As shown in Figures 1 to 9, in the illustrated embodiments, at least a portion of the bridging arm 111 is bent relative to the surface of the lead body 10. For example, the bridging arm 111 is roughly bent 90 degrees relative to the surface of the lead body 10, so that the surface of the elastic cantilever 110 is roughly perpendicular to the surface of the lead body 10.

As shown in Figures 1 to 9, in the illustrated embodiments, the frame body 2 has a protruding portion 211 protruding into the receiving slot 21, and at least a portion of the bridging arm 111 and at least a portion of the fixed end 110a of the elastic cantilever 110 are wrapped in the protruding portion 211. In the illustrated embodiment, the protruding portion 211 is located at the corner of the receiving slot 21 and connected to the adjacent two sides of the receiving slot 21.

As shown in Figures 1 to 9, in the illustrated embodiments, the frame body 2 has a front and a back, and the frame body 2 has a limit beam 212 located on its back and bridging between two sides of the receiving slot 21. The limit beam 212 is located between the pair of elastic cantilevers 110 and extends along the length direction of the elastic cantilevers 110. When the terminal 3 is installed on the charging base lead frame, one end 30 of the terminal 3 is inserted between the free ends 110b of the pair of elastic cantilevers 110, and the end face 30a of one end of the terminal 3 is against the limit beam 212.

As shown in Figures 1 to 9, in the illustrated embodiment, a through hole 22 is also formed on the frame body 2 that allows the charging terminal (not shown) to pass through.

As shown in Figures 1 to 9, in the illustrated embodiments, multiple leads 1, 1' also include a second lead 1' for electrical connection to the temperature sensor of the charging base. The pins 12 and 12' of the first lead 1 and the second lead 1' are exposed from one side of the frame body 2 and arranged in a row.

As shown in Figures 1 to 9, in the illustrated embodiment, the first lead 1 further includes a pair of guide wings 112. The pair of guide wings 112 are respectively connected to one sides of the free ends 110b of the pair of elastic cantilevers 110. The pair of guide wings 112 are flared outward in an octagonal shape to guide the end 30 of the terminal 3 to be inserted between the free ends 110b of the pair of elastic cantilevers 110.

As shown in Figures 1 to 9, in the illustrated embodiments, each of the multiple leads 1 and 1' is an integrated stamping molded part, and the frame body 2 and the multiple leads 1 and 1' are formed into an integrated injection molded part, so that the injection molded frame body 2 to directly engage with multiple leads 1 and 1'. This can reduce manufacturing costs.

As shown in Figures 1 to 9, in an exemplary embodiment of the present invention, a charging base lead frame assembly is also disclosed. The charging base lead frame assembly includes: the above charging base lead frame and a temperature sensor (not shown). The temperature sensor is installed on the frame body 2 of the charging base lead frame to detect the temperature of the charging terminal (not shown) of the charging base. The temperature sensor is electrically connected to the second lead 1' in the charging base lead frame.

As shown in Figures 1 to 9, in an exemplary embodiment of the present invention, a charging base is also disclosed. The charging base includes a housing (not shown), the above charging base lead frame, and a terminal 3. The charging base lead frame is installed in the housing. The terminal 3 is installed in the housing and clamped between the pair of elastic cantilevers 110 of the first lead 1 of the charging base lead frame.

As shown in Figures 1 to 9, in an exemplary embodiment of the present invention, a charging base is also disclosed. The charging base includes a housing (not shown), the above charging base lead frame assembly, and a terminal 3. The charging base lead frame is installed in the housing. The terminal 3 is installed in the housing and clamped between the pair of elastic cantilevers 110 of the first lead 1 of the charging base lead frame.

As shown in Figures 1 to 9, in the illustrated embodiment, the aforementioned terminal 3 can be the signal terminal of the charging station.

As shown in Figures 1 to 9, in the illustrated embodiment, the charging base also includes a charging terminal. The charging terminal is installed in the housing and passes through the charging base lead frame through the through hole 22 on the frame body 2.

It should be appreciated for those skilled in this art that the above embodiments are intended to be illustrated, and not restrictive. For example, many modifications may be made to the above embodiments by those skilled in this art, and various features described in different embodiments may be freely combined with each other without conflicting in configuration or principle.

Although several exemplary embodiments have been shown and described, it would be appreciated by those skilled in the art that various changes or modifications may be made in these embodiments without departing from the principles and spirit of the disclosure, the scope of which is defined in the claims and their equivalents.

As used herein, an element recited in the singular and proceeded with the word "a" or "an" should be understood as not excluding plural of said elements or steps, unless such exclusion is explicitly stated. Furthermore, references to "one embodiment" of the present invention are not intended to be interpreted as excluding the existence of additional embodiments that also incorporate the recited features. Moreover, unless explicitly stated to the contrary, embodiments "comprising" or "having" an element or a plurality of elements having a particular property may include additional such elements not having that property.

## Claims

1. A charging base lead frame, **characterized by** comprising:
a frame body (2) which is formed with a receiving slot (21); and
a plurality of leads (1, 1') which are fixed to the frame body (2) and include a first lead (1) for electrical connection to a terminal (3) of a charging base,
wherein the first lead (1) comprises of:
a lead body (10) which is fixed to the frame body (2);
a pair of elastic cantilevers (110) connected to the lead body (10) and suspended in the receiving slot (21) for clamping the terminal (3); and
a pair of bridging arms (111) for respectively connecting the fixed ends (110a) of the pair of elastic cantilevers (110) to the lead body (10),
wherein at least a portion of the fixed end (110a) of the elastic cantilever (110) is wrapped in the frame body (2).

2. The charging base lead frame according to claim 1, **characterized in that**
a portion of the bridging arm (111) and a portion of the fixed end (110a) of the elastic cantilever (110) are wrapped in the frame body (2); and
the part of the fixed end (110a) of the elastic cantilever (110) and the part of the bridging arm (111) that are not wrapped in the frame body (2) are suspended in the receiving slot (21).

3. The charging base lead frame according to claim 1, **characterized in that**
all of the bridging arm (111) and all of the fixed end (110a) of the elastic cantilever (110) are wrapped in the frame body (2); and
the rest part of the elastic cantilever (110) except for the fixed end (110a) is exposed from the frame body (2) and suspended in the receiving slot (21).

4. The charging base lead frame according to claim 1, **characterized in that**
the bridging arm (111) is located at one side of the width direction of the elastic cantilever (110) and is connected to an side edge of the fixed end (110a) of the elastic cantilever (110).

5. The charging base lead frame according to claim 4, **characterized in that**
the width direction of the bridging arm (111) is parallel to the length direction of the elastic cantilever (110), and the width of the bridging arm (111) is smaller than the width of the elastic cantilever (110).

6. The charging base lead frame according to claim 5, **characterized in that**
the width of the bridging arm (111) is 10% to 60% of the width of the elastic cantilever (110); or
the width of the bridging arm (111) is 20% to 50% of the width of the elastic cantilever (110).

7. The charging base lead frame according to claim 4, **characterized in that**
the one side of the width direction of the bridging arm (111) is flush with the end side of the fixed end (110a) of the elastic cantilever (110); and
at least a portion of the bridging arm (111) and at least a portion of the fixed end (110a) of the elastic cantilever (110) are wrapped in the frame body (2).

8. The charging base lead frame according to claim 4, **characterized in that**
at least a part of the bridging arm (111) is bent relative to the surface of the lead body (10), so that the surface of the elastic cantilever (110) is roughly perpendicular to the surface of the lead body (10).

9. The charging base lead frame according to claim 1, **characterized in that**
the frame body (2) has a protruding part (211) protruding into the receiving slot (21), and at least a portion of the bridging arm (111) and at least a portion of the fixed end (110a) of the elastic cantilever (110) are wrapped in the protruding part (211).

10. The charging base lead frame according to claim 1, **characterized in that**
the frame body (2) has a front and a back, and the frame body (2) has a limit beam (212) located on its back and bridging between the two sides of the receiving slot (21);
the limit beam (212) is located between the pair of elastic cantilevers (110) and extends along the length direction of the elastic cantilevers (110);
when the terminal (3) is installed on the charging base lead frame, one end (30) of the terminal (3) is inserted between the free ends (110b) of the pair of elastic cantilevers (110), and the end face (30a) of the one end of the terminal (3) is against the limit beam (212).

11. The charging base lead frame according to claim 1, **characterized in that**
the plurality of leads (1, 1') also include a second lead (1') for electrical connection to a temperature sensor of the charging base;
the pins (12, 12') of the first lead (1) and the second lead (1') are exposed from one side of the frame body (2) and arranged in a row.

12. The charging base lead frame according to any one of claims 1-11, **characterized in that**
the first lead (1) further includes a pair of guide wings (112), which are respectively connected to one sides of the free ends (110b) of the pair of elastic cantilevers (110);
the pair of guide wings (112) are flared outward in an octagonal shape to guide the one end (30) of the terminal (3) to be inserted between the free ends (110b) of the pair of elastic cantilevers (110).

13. The charging base lead frame according to any one of claims 1-11, **characterized in that**
each of the plurality of leads (1, 1') is an integrated stamping molded part, the frame body (2) and the plurality of leads (1, 1') are formed into an integrated injection molded part, so that the frame body (2) is directly bonded to the plurality of leads (1, 1').

14. A charging base lead frame assembly, **characterized by** comprising:
the charging base lead frame according to any one of claims 1-13; and
a temperature sensor which is installed on the frame body (2) of the charging base lead frame to detect a temperature of a charging terminal of a charging base,
wherein the temperature sensor is electrically connected to the second lead (1') in the charging base lead frame.

15. A charging base, **characterized by** comprising:
a housing;
the charging base lead frame as claimed in any one of claims 1-13 or the charging base lead frame assembly as claimed in claim 14, which is installed in the housing; and
a terminal (3) which is installed in the housing and clamped between the pair of elastic cantilevers (110) of the first lead (1) of the charging base lead frame.
